(19)

Europäisches Patentamt
European Patent Office
Office européen des brevets

(11) **EP 3 367 771 A1**

(12) **EUROPEAN PATENT APPLICATION**

(43) Date of publication:
**29.08.2018 Bulletin 2018/35**

(51) Int Cl.:
*H05K 7/20* (2006.01)          *F24F 7/02* (2006.01)
*F24F 7/06* (2006.01)          *F24F 7/10* (2006.01)

(21) Application number: **18162564.1**

(22) Date of filing: **17.08.2012**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **12.09.2011  US 201113230809**

(62) Document number(s) of the earlier application(s) in accordance with Art. 76 EPC:
**12831738.5 / 2 764 297**

(71) Applicant: **Excalibur IP, LLC
New York, NY 10017 (US)**

(72) Inventors:
• **NOTEBOOM, Scott
  San Jose, CA 95123 (US)**
• **ROBISON, Albert, Dell
  Los Gatos, CA 95033 (US)**

(74) Representative: **Boult Wade Tennant LLP
Verulam Gardens
70 Gray's Inn Road
London WC1X 8BT (GB)**

Remarks:
This application was filed on 19-03-2018 as a divisional application to the application mentioned under INID code 62.

(54) **INTEGRATED BUILDING BASED AIR HANDLER FOR SERVER FARM COOLING SYSTEM**

(57)      An air handler building structure is disclosed, which includes a floor, a plurality of lateral walls, a roof and one or more openings located either on the roof or on at least one of the lateral walls. The lateral walls include a lower and an upper lateral walls opposing to each other having different respective heights determined in accordance with a ratio. The roof has a pitch consistent with die ratio associated with the lower and upper lateral walls. The shape of the building structure allows air within the building structure to rise via natural convection. In addition, a first dimension along a first direction defined between the lower and upper lateral walls relative to a second dimension along a second direction perpendicular to the first direction is such that the building structure provides access to outside natural air via one or more openings on the lower lateral wall.

FIG. 14

EP 3 367 771 A1

**Description**

CROSS-REFERENCE TO RELATED APPLICATIONS

The present application is a continuation in part (CIP) and claims priority to U.S. Patent Application No. 12/500,520 filed July 9, 2009 entitled, INTEGRATED BUILDING BASED AIR HANDLER FOR SERVER FARM COOLING SYSTEM, of which is incorporated herein by reference in its entirety.

TECHNICAL FIELD

The present disclosure relates generally to cooling systems.

BACKGROUND

The rapid growth of Internet services such as Web email, Web search, Web site hosting, and Web video sharing is creating increasingly high demand for computing and storage power from servers in data centers. While the performance of servers is improving, the power consumption of servers is also rising despite efforts in low power design of integrated circuits. For example, one of the most widely used server processors, AMD's Opteron processor, runs at up to 95 watts. Intel's Xeon server processor runs at between 110 and 165 watts. Processors are only part of a server, however; other parts in a server such as storage devices consume additional power.

Servers are typically placed in racks in a data center. There are a variety of physical configurations for racks. A typical rack configuration includes mounting rails to which multiple units of equipment, such as server blades, are mounted and stacked vertically within the rack. One of the most widely used 19-inch rack is a standardized system for mounting equipment such as 1U or 2U servers. One rack unit on this type of rack typically is 1.75 inches high and 19 inches wide. A rack-mounted unit that can be installed in one rack unit is commonly designated as a 1U server. In data centers, a standard rack is usually densely populated with servers, storage devices, switches, and/or telecommunications equipment. One or more cooling fans may be mounted internally within a rack-mounted unit to cool the unit. In some data centers, fanless rack-mounted units are used to increase density and to reduce noise.

Rack-mounted units may comprise servers, storage devices, and communication devices. Most rack-mounted units have relatively wide ranges of tolerable operating temperature and humidity requirements. For example, the system operating temperature range of the Hewlett-Packard (HP) ProLiant DL365 G5 Quad-Core Opteron processor server models is between 50°F and 95°F; the system operating humidity range for the same models is between 10% and 90% relative humidity. The system operating temperature range of the NetApp FAS6000 series filers is between 50°F and 105°F; the system operating humidity range for the same models is between 20% and 80% relative humidity. There are many places around the globe such as parts of the northeast and northwest region of the United States where natural cool air may be suitable to cool servers such as the HP ProLiant servers and the NetApp filers during certain periods of a year.

The power consumption of a rack densely stacked with servers powered by Opteron or Xeon processors may be between 7,000 and 15,000 watts. As a result, server racks can produce very concentrated heat loads. The heat dissipated by the servers in the racks is exhausted to the data center room. The heat collectively generated by densely populated racks can have an adverse effect on the performance and reliability of the equipment installed in the racks, since they rely on the surrounding air for cooling. Accordingly, heating, ventilation, air conditioning (HVAC) systems are often an important part of the design of an efficient data center.

A typical data center consumes 10 to 40 megawatts of power. The majority of energy consumption is divided between the operation of servers and HVAC systems. HVAC systems have been estimated to account for between 25 to 40 per cent of power use in data centers. For a data center that consumes 40 megawatts of power, the HAVC systems may consume 10 to 16 megawatts of power. Significant cost savings can be achieved by utilizing efficient cooling systems and methods that reduce energy use. For example, reducing the power consumption of HVAC systems from 25 percent to 10 percent of power used in data centers translates to a savings of 6 megawatts of power which is enough to power thousands of residential homes. The percentage of power used to cool the servers in a data center is referred to as the cost-to-cool efficiency for a data center. Improving the cost-to-cool efficiency for a data center is one of the important goals of efficient data center design. For example, for a 40 megawatt data center, the monthly electricity cost is about $1.46 million assuming 730 hours of operation per month and $0.05 per kilowatt hour. Improving the cost to cool efficiency from 25% to 10% translates to a saving of $219,000 per month or $2.63 million a year.

In a data center room, server racks are typically laid out in rows with alternating cold and hot aisles between them. All servers are installed into the racks to achieve a front-to-back airflow pattern that draws conditioned air in from the cold rows, located in front of the rack, and ejects heat out through the hot rows behind the racks. A raised floor room design is commonly used to accommodate an underfloor air distribution system, where cooled air is supplied through vents in the raised floor along the cold aisles.

A factor in efficient cooling of data center is to manage the air flow and circulation inside a data center. Computer Room Air Conditioners (CRAC) units supply cold air through floor tiles including vents between the racks. In addition to servers, CRAC units consume significant amounts of power as welt. One CRAC unit may have up to three 5 horsepower motors and up to 150 CRAC units may be needed to cool a data center. The CRAC units collectively consume significant amounts of power in a data center. For example, in a data center room with hot and cold row configuration, hot air from the hot rows is moved out of the hot row and circulated to the CRAC units. The CRAC units cool the air. Fans powered by the motors of the CRAC units supply the cooled air to an underfloor plenum defined by the raised sub-floor. The pressure created by driving the cooled air into the underfloor plenum drives the cooled air upwardly through vents in the subfloor, supplying it to the cold aisles where the server racks are facing. To achieve a sufficient air flow rate, hundreds of powerful CRAC units may be installed throughout a typical data center room. However, since CRAC units are generally installed at the corners of the data center room, their ability to efficiently increase air flow rate is negatively impacted. The cost of building a raised floor generally is high and the cooling efficiency generally is low due to inefficient air movement inside the data center room. In addition, the location of the floor vents requires careful planning throughout the design and construction of the data center to prevent short circuiting of supply air. Removing tiles to fix hot spots can cause problems throughout the system.

SUMMARY

The present teaching relates to cooling systems.

In one example, an air handler building structure is disclosed, which includes a floor, a plurality of lateral walls, a roof, and one or more openings located either on the roof or on at least one of the lateral walls. The lateral walls include a lower and an upper lateral walls opposing to each other having different respective heights determined in accordance with a ratio. The roof has a pitch consistent with the ratio associated with the lower and upper lateral walls, The shape of the building structure allows air within the building structure to rise via natural convection. In addition, a first dimension along a first direction defined between the lower and upper lateral walls relative to a second dimension along a second direction perpendicular to the first direction is such that the building structure provides access to outside natural air via one or more openings on the lower lateral wall.

In another example, a server cooling system is disclosed, which includes a first space defined by a floor, one or more lateral walls, and a ceiling, having a plurality of servers installed therein, and second space defined by the ceiling and a roof. One or more openings are located on at least one of the ceiling, the roof, and at least one of the one or more lateral walls. The server cooling system also includes an air inlet coupled with a first lateral wall and operable to allow outside natural air to enter, one or more air-handling units coupled with the air inlet to draw the outside natural air and to provide air to the first space, and an air outlet coupled with a second lateral wall and operable to allow air in the second space to exit. The server cooling system further includes a control system configured to control the one or more air-handling units to provide air to the first space in accordance with temperatures measured within and outside of the first space.

In still another example, a server cooling system is disclosed, which includes a first space defined by a floor, a plurality of lateral walls, and a ceiling, and a second space defined by the ceiling and a sloped roof constructed in accordance with a pitch. One or more openings are located on at least one of the roof, the ceiling, and at least one of the lateral walls, that enable outside natural air to enter the first space and air in the second space to exit by natural convection. The server cooling system also includes an interior space inside the first space, that is substantially enclosed and engaging the ceiling, and a rack engaging the interior space in a substantially sealed manner and having a plurality of rack-mounted servers mounted thereon. Respective front faces of the rack-mounted servers interface with the first space respective back faces of the rack-mounted servers interface with the interior space. Each rack-mounted server includes one or more fans installed therein operable to draw air from the first space through its front face and expel heated air to the interior space through its back face.

In yet another example, an air handler building structure is disclosed, which includes a floor, a plurality of lateral walls, a roof portion, a protruding portion, and one or more openings located on at least one of the roof portion, at least one of the lateral walls, and the protruding portion. The roof portion has opposing sides, each having a pitch. The protruding portion extends above the roof portion. In addition, the shape of the building structure allows outside natural air to enter through one or more openings on at least one of the lateral walls via natural convection and exit through one or more openings on at least one of the roof portion and the protruding portion.

The following detailed description together with the accompanying drawings will provide a better understanding of the nature and advantages of various embodiments of the present invention.

DESCRIPTION OF THE DRAWINGS

FIG. 1 is a diagram showing an exemplary server cooling system;
FIG. 2 is a diagram showing an example server cooling system wherein the server cooling system comprises an attic space;
FIG. 3 is a diagram showing an example server cooling system wherein air is re-circulated inside the example server cooling system:
FIG. 4 is a diagram showing an example server cooling system with a hot row enclosure and a cold row enclosure;
FIG. 5 is a diagram showing an example server cooling system with a hot row enclosure and a cold row enclosure wherein air is re-circulated inside the a server cooling system;
FIG. 6 is a diagram showing an example server coaling system with a single-sloped roof;
FIG. 7 is a diagram showing a top view of an example server cooling system with a single-sloped roof;
FIG. 8 is a diagram showing an example server cooling system with a gable roof;
FIG. 9 is a diagram showing an example server cooling system with an air mixing chamber;
FIGS. 10A and 10B are diagrams showing an example air handler building structure;
FIG. 11 is a diagram showing an example server cooling system;
FIG. 12 is a diagram showing another example server cooling system;
FIG. 13 illustrates a cross-section of an other example of an air handler building structure; and
FIG. 14 illustrates a cross section of yet another exemplary air handler building structure.

DESCRIPTION OF EXAMPLE EMBODIMENT(S)

The following example embodiments and their aspects are described and illustrated in conjunction with apparatuses, methods, and systems which are meant to be illustrative examples, not limiting in scope.

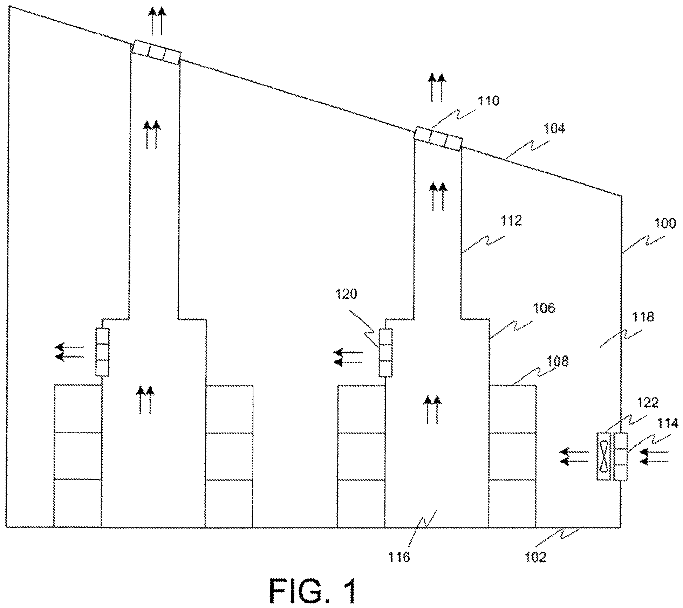

F1G. 1 illustrates an example server cooling system comprising lateral walls 100, a floor 102, a roof 104, an enclosure 106, and a server rack 108. The lateral walls 100, the floor 102 and the roof 104 define an inside space 118. Floor 102 may or may not be a raised sub-floor. There may be valved openings 110 on the roof 104 and valved openings 114 on the lateral walls 100. The valved openings may be connected to a control system which is operable to selectively open or close each valved opening. The enclosure 106 may have a frame, panels, doors, and server rack ports. A server rack port is an opening in the enclosure 106 that can be connected to one or more server racks 108. The enclosure 106 may be made of a variety of materials such as steel, composite materials, or carbon materials that create a housing defining an interior space 116 that is substantially sealed from the inside space 118. The enclosure 106 comprises at least one server rack port that allows one or more rack-mounted units installed in the server rack 108 to interface with the interior space 116. In one implementation, the a server rack port is an opening configured to substantially conform to the outer contours of, and accommodate, a server rack 108. One or more edges of the server rack port may include a gasket or other component that contacts the server rack 108 and forms a substantially sealed interface. The server rack 108 may be removably connected to the enclosure 106 through the server rack port in a substantially sealed manner. In some embodiments, one or more rack-mounted units are installed in the server rack 108 such that respective front faces of the rack-mounted units interface with the inside space 118, and that respective back faces of the rack-mounted units interface with the interior space 116 defined by the enclosure 106. An example rack-mounted unit may be a server blade, data storage array or other functional device. A front-to-back air flow through the rack-mounted units installed in the server rack 108 draws cooling air from the inside space 118 and expels heated air to the interior space 116.

The enclosure 106 may be connected to valved openings 110 on the roof 104 through a connector 112 on a top side of the enclosure. In some embodiments, the connector 112 may be made of metal ducts. In other embodiments, the connector 112 may be made of soft and flexible materials so that the enclosure may be removably connected to the valved openings 110. In some embodiments, the enclosure 106 may be mounted directly to the floor 102. In other embodiments, the enclosure 106 may have wheels on the bottom side and may be easily moved around in a data center.

In some embodiments, the server rack 108 may be sparsely populated with servers and other equipment. Since servers and other equipment are stacked vertically within the rack, the scarcity may create open gaps to the interior space 116. Air may leak from the interior space 116 through the open gaps. To prevent air leakage, the gaps may be blocked by panels mounted to the server rack 108 that prevent air from escaping and entering the enclosure 106 through the gaps.

In some embodiments, one or more air handling units 122 may draw external cool air into the inside space 118. The cool air enters the server cooling system through valved openings 114 on the lateral walls 100. One or more fans draw the cool air from the inside space 118 through the front faces of the one or more rack-mounted units and expel heated air through the back faces of the one or more rack-mounted units to the interior space 116. The heated air passes through the connector 112 and leaves the interior space 116 through the valved openings 110 on the roof 110. In some embodiments, the cooling fans mounted internally within the rack-mounted units installed in the rack 108 draw the cool air from the inside space 118 and expel heated air to the interior space 116; no additional air handling units, in one implementation, are need to cool the rack-mounted units. In other embodiments where fanless rack-mounted units are installed in the rack 108, one or more fans may be installed on one side of the rack 108 to draw air through the rack-mounted units from the inside space 118 to the interior space 116 to cool the rack-mounted units installed in the rack 108.

In some embodiments, there may be valved openings 120 on the enclosure 116. A control system is operably connected to the valved openings 120, the valved openings 110 on the roof 104, and the valved openings 114 on the lateral walls 100. The control system is operable to selectively activate each of the valved openings based on temperatures observed within and outside the inside space 118 to achieve one or more desired air flows. When the air external to the inside space 118 is not suitable to be introduced to the inside space 118, the control system closes the valved openings 110 and 114, and opens up the valved openings 120. To cool air in the inside space 118, one or more cooling units may be used. In some embodiments, the cooling units may be evaporative coolers which are devices that cool air through the simple evaporation of water. Compared with refrigeration or absorption air conditioning, evaporative cooling may be more energy efficient. Cooling air is drawn from the inside space 118 through the rack-mounted units and heated air is expelled to the interior space 116 defined by the enclosure 106. Heated air inside the enclosure 106 is exhausted to the inside space 118 through the valved openings 120. In some embodiments, one or more fans may be used to exhaust the heated air out of the enclosure 106.

In other embodiments, one or more cooling units may be used while external air is introduced to the inside space 118. The control system may open the valved openings 110, 114, and 120 simultaneously. Evaporative cooling units may be used in close proximity to the valved openings 114 so that the external air may be cooled while being introduced to the inside space 118.

In yet other embodiments, the control system may open the valved openings 110, and close valved openings 114 and 120 when the difference in temperature between the outside and the insider space reaches certain configurable threshold values. In other embodiments, the control system may close valved openings 110, and open up valved openings 114 and 120. To cool the air in the inside space 120, one or more evaporative cooling units may be placed in the inside space 120 to provide cooling.

In some embodiments, the roof 104 comprises a single-sloped roof which may be easy to manufacture and install. In other embodiments, other types of roof configurations, such as a gable roof, may be used. The lateral walls 100, the floor 102, and the roof 104 may be pre-manufactured in a factory and assembled on the construction site where a data center is to be built. Pre-manufactured units may significantly reduce the cost to build a data center. One of the cost advantages of the integrated building based air handler for server farm cooling system is the convenience and low cost of pre-manufacture parts of the system and the ease of installation of pre-manufactured parts in a data center.

In some embodiments, the integrated building based air handler for server farm cooling system illustrated in FIG. 1 obviates the need for raised subfloors, CRAC units and water chillers. A large number of parts of the cooling system may be pre-manufactured and easily assembled. Natural cool air may be used to cool the servers. Cooling fans installed internally within the servers may provide the needed air flow to draw cooling air to cool the servers; CRAC units and raised subfloors may no longer be needed. Efficient evaporative coolers may replace the water chillers which are costly to install and operate. Overall, the cooling systems described herein may significantly reduce the construction cost, and electricity power and water usage, of server farm deployments.

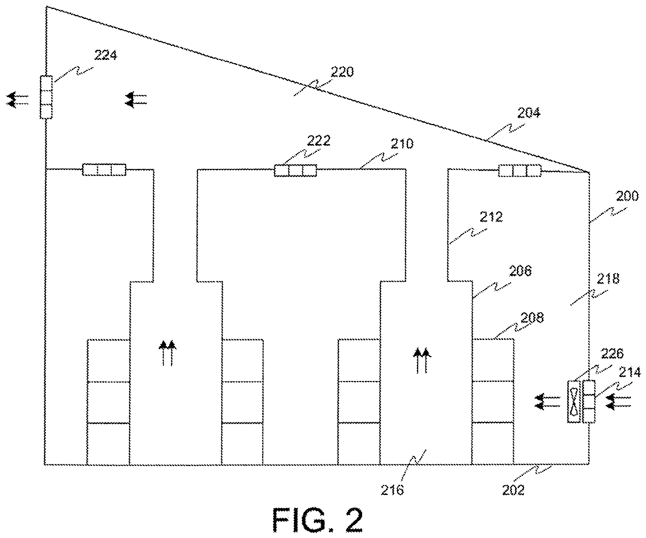

FIG. 2 illustrates another example server cooling system comprising lateral walls 200, a floor 202, a roof 204, an enclosure 206, a server rack 208, and a ceiling 210. The example cooling system in FIG. 2 is similar to that in FIG. 1 except that the ceiling 210 and the roof 204 define an attic space 220. The lateral walls 200, the floor 202 and the ceiling 210 define an inside space 218. One or more valved openings 222 are coupled to the ceiling 210. There may be valved openings 224 on the roof 204 and valved openings 214 on the lateral walls 200. The enclosure 206 is operably connected to the attic space 220 through a connector 212.

In some embodiments, one or more air handling units 226 may draw external cool air into the inside space 218. One or more fans draw the cool air from the inside space 218 through the front faces of the one or more rack-mounted units installed in the rack 208 and expel heated air through the back faces of the rack-mounted units to the interior space 216. The heated air passes through the connector 212 and enters the attic space 220. In some embodiments, the cooling fans mounted internally within the rack-mounted units installed in the rack 208 draw the cooling air to the interior space 216 and no additional air handling units are needed. In other embodiments where fanless rack-mounted units are installed in the rack 208, one or more fans may be installed on one side of the rack 208 to draw air from the inside space to the interior space 216 to cool the rack-mounted units installed in the server rack 208. Heated air rises to the attic space 220 and is exhausted out of the cooling system through the valved openings 224.

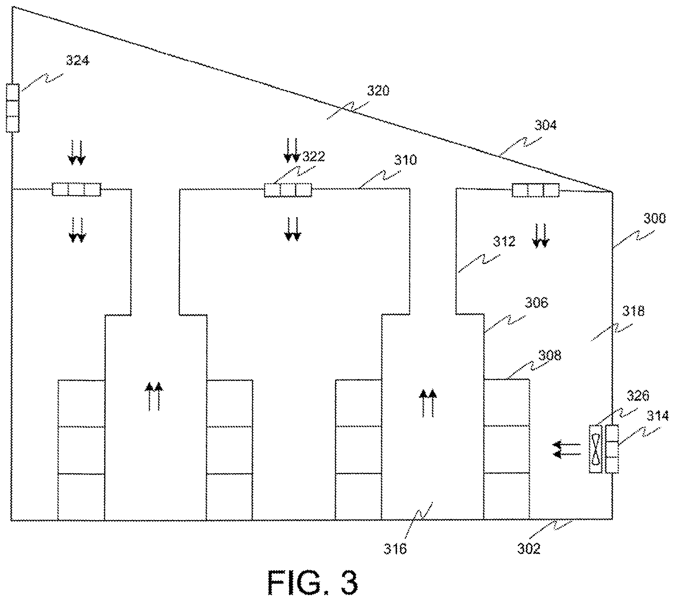

FIG. 3 illustrates another example server cooling system comprising lateral walls 300, a floor 303, a roof 304, an enclosure 306, a server rack 308, and a ceiling 310, The lateral walls 300, the floor 302 and the ceiling 310 define an inside space 318. The roof 304 and the ceiling 310 define an attic space 330. One or more valved openings 322 are coupled to the ceiling 310. There may be valved openings 324 on the roof 304 and valved openings 314 on the lateral walls 300. The enclosure 306 is operably connected to the attic space 320 through a connector 312. The example cooling system in FIG. 3 is similar to that in FIG. 2 except that external air may not be introduced into the inside space 318 and that heated air in the attic space 330, at some points in time, may not be exhausted to the outside of the example server cooling system; rather, the heated air may be mixed into the inside space 318 as needed to maintain a desired operating temperature.

In one embodiment, the valved openings 322, 324, and 314 are connected to a control system which is operable to selectively activate each of the valved openings based on temperatures observed within and outside the inside space 318. When the external air is not suitable to be introduced to the inside space 318, the control system closes the valved openings 314 and 324, and opens up the valved openings 322. To cool air in the inside space 318, one or more cooling units may be used. In some embodiments, the cooling units may be evaporative coolers. Cooling air is drawn from the inside space 318 through the rack-mounted units and the heated air is expelled to the interior space 316 defined by the enclosure 306. Heated air inside the enclosure 306 is exhausted to the attic space 320 through the connector 312 and re-circulated to the inside space 318 through the valved openings 322 coupled to the ceiling 310. In some embodiments, one or more fans may be used to exhaust the heated air out of the enclosure 306 to the attic space 320 and/or recirculate at least some of the heated air to the inside space 318.

In other embodiments, one or more cooling units may be used while the external air is introduced to the inside space 318. The control system may open the valved openings 314, 322, and 324 simultaneously or at selected times individually. Evaporative cooling units may be used in close proximity to the valved openings 314 so that external air may be cooled while being introduced to the inside space 318.

In yet other embodiments, the control system may open up the valved openings 314 and 322, and close the valved openings 324. Evaporative cooling units may be used in close proximity to the valved openings 314 and/or the valved openings 322 to provide efficient cooling in the inside space 318. In other embodiments, the control system may close valved openings 314, and open up valved openings 322 and 324. In one embodiment, the control system may close valved openings 314 and 322, and open up the valved openings 324. The control system monitors the temperatures within the inside space 318, within the attic space 320 and the temperature outside. When the difference among the three observed temperatures reaches one or more configurable threshold vales, the control system may selectively open up or close each valved opening.

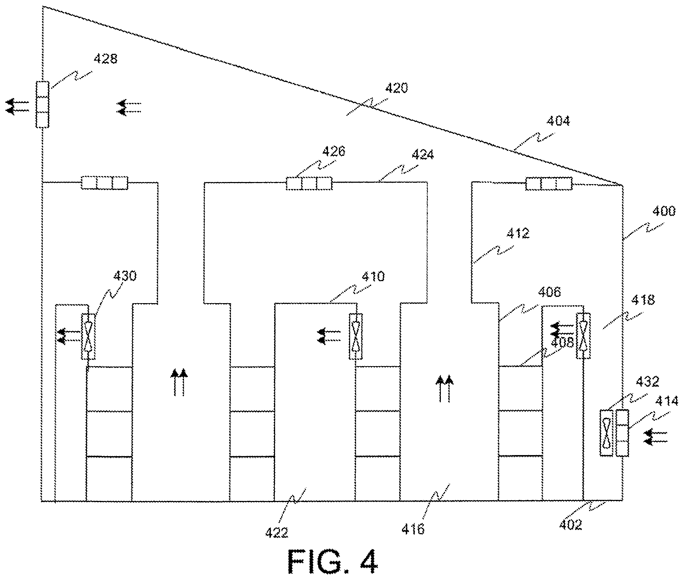

FIG. 4 illustrates another example server cooling system comprising lateral walls 400, a floor 402, a roof 404, a hot row enclosure 406, a server rack 408, a cold row enclosure 410, and a ceiling 424. The example cooling system in FIG. 4 is similar to that in FIG. 3 except that one or more cold row enclosures are used to provide efficient cooling of servers installed in n the rack 408.

The lateral walls 400, the floor 402 and the ceiling 424 define an inside space 418. The ceiling 424 and the roof 404 define an attic space 420. In some embodiments, one or more valved openings 426 may be coupled to the ceiling 424. In some other embodiments, the hot row enclosure 406 comprises at least one server rack port that allows one or more rack-mounted units to interface with a hot row interior space 416. The cold row enclosure 410 also comprises at least one server rack port that allows one or more rack-mounted units to interface with a cold row interior space 422. The server rack 408 may be removably connected to the hot row enclosure 406 through the server rack port in a substantially scaled manner. The server rack 408 may also be removably connected to the cold row enclosure 410 through the server rack port in a substantially sealed manner. In some embodiments, the rack-mounted units are installed in the server rack 408 such that respective front faces of the rack-mounted units interface with the cold row interior space 422, and that respective back faces of the rack-mounted units interface with the hot row interior space 416. In some embodiments, the hot row enclosure 406 may be operably connected to the attic space 420 through a connector 412. In some other embodiments, the cold row enclosure may comprise a fan unit 430 to draw air from the cold row interior space 422 through the front faces of the rack-mounted units installed in the rack 408 to cool the rack-mounted units; the heated air is ejected to the hot row interior space 416 through the back faces of the rack-mounted units.

In some embodiments, one or more air handling units 432 may draw external cool air into the inside space 418. The cool air enters the server cooling system through valved openings 414 on the lateral walls 400. The one or more fans 430 draw the cool air from the inside space 418 to the cold row interior space 422 through one or more openings on the cold row enclosure 410. In some embodiments, each cold row enclosure 410 may be operably connected to the valved openings 414 so that the external cool air may be drawn to the cold row interior space 422. In some other embodiments, the cooling fans mounted internally within the rack-mounted units draw the cool air from the cold row interior space 422. The cool air flows through the front faces of the one or more rack-mounted units installed in the rack 408 and expel heated air through the back faces of the one or more rack-mounted units to hot row interior space 416. The heated air passes through the connector 412 and enters the attic space 420. In some embodiments, the heated air inside the attic space 420 may be exhausted out of the cooling system through the valved openings 428.

In some embodiments where fanless rack-mounted units are installed in the rack 408, one or more fans may be installed on one side of the rack 408 to draw air from the inside space 418 to the interior space 416 to cool the rack-mounted units installed in the rack 408. In other embodiments, the one or more fans 422 may provide the needed power for the cool air to flow from the cold row interior space 422 to the hot row interior space 416.

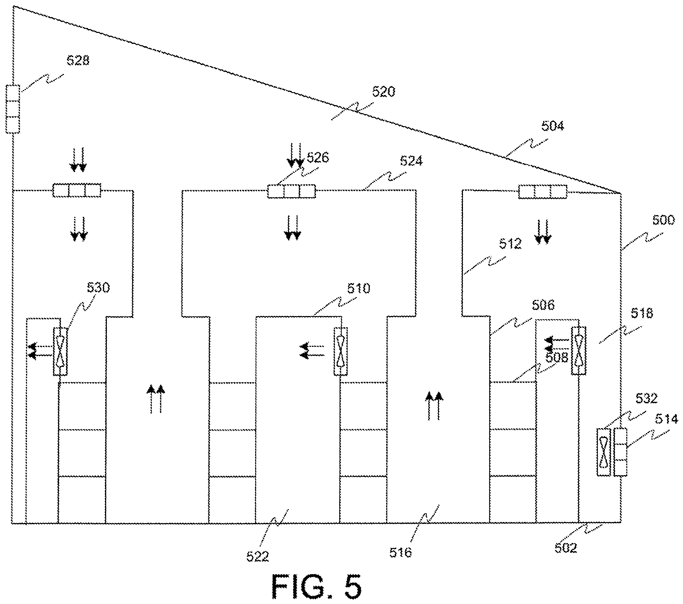

FIG. 5 illustrates another example server cooling system comprising lateral walls 500, a floor 502, a roof 504, a hot row enclosure 506, a server rack 508, a cold row enclosure 510, and a ceiling 524. The lateral walls 500, the floor 502 and the ceiling 524 define an inside space 518. The ceiling 524 and the roof 504 define an attic space 520. The example cooling system in FIG. 5 is similar to that in FIG. 4 except that external air may not be introduced into the inside space 518 and that heated air in the attic space 520 may not be exhausted to the outside of the example server cooling system.

In some embodiments, one or more valved openings 526 may be coupled to the ceiling 524. The valved openings 514, 528, and 526 are operably connected to a control system which is operable to selectively activate each of the valved openings based on temperatures observed within and outside the inside space 518 and/or the attic space 520. When the external air is not suitable to be introduced to the inside space 518, the control system closes the valved openings 514 and 528, and opens up the valved openings 526. To cool air in the inside space 518, one or more cooling units 532 may be used. In some embodiments, the cooling units 532 may be evaporative coolers. Cooling air is drawn from the inside space 518 to the cold row interior space 522. In some embodiments, one or more fans 530 may be used to draw cooling air into the cold row enclosure 510. The cooling air is drawn from the cold row interior space 522 through the rack-mounted units installed in the rack 508; the heated air is expelled to the hot row interior space 516 defined by the enclosure 506. Heated air enters the attic space 520 through the connector 512 and is re-circulated to the inside space 518 through the valved openings 526 coupled to the ceiling 524. In some embodiments, one or more fans may be used to exhaust the heated air out of the enclosure 506 to the attic space 520 and re-circulated to the inside space 518.

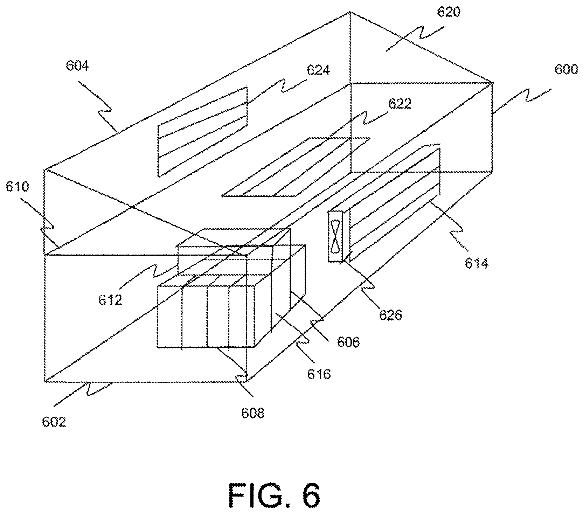

FIG. 6 illustrates a three dimensional view of an example server cooling system comprising lateral walls 600, a floor 602, a roof 604, an enclosure 606, a server rack 608, and a ceiling 610. The lateral walls 600, the floor 602 and the ceiling 610 define an inside space 618. The roof 604 and the ceiling 610 define an attic space 620. The enclosure 606 defines an interior space 616. One or more valved openings 622 are coupled to the ceiling 610. There may be valved openings 624 on the roof 604 and valved openings 614 on the lateral walls 600. The enclosure 606 is operably connected to the attic space 620 through a connector 612. In some embodiments, one or more rack-mounted units are installed in the rack 608 such that respective front feces of the rack-mounted units interface with the inside space 618, and that respective back faces of the rack-mounted units interface with the interior space 616. In some embodiments, external cool air may be drawn into the inside space 618 through valved openings 614. The cool air may be drawn from the inside space 618 by cooling fans mounted internally within the rack-mounted units installed in the rack 608; the heated air is ejected into the interior space 616 and enters the attic space 620 through the connector 612. In other embodiments where fanless rack-mounted units are installed in the rack 608, one or more fans may be used to draw cooling air from the inside space 618 to the interior space 616. In some embodiments, the air handling units 626 may be used to draw external cool airto the inside space 618 through valved openings 614. The valved openings 614, 624, and 622 are operably connected to a control system which is operable to selectively activate each of the valved openings based on temperatures observed within and outside the inside space 618 and/or the attic space 620. When the external air is not suitable to be introduced to the inside space 618, the control system closes the valved openings 614 and 624, and opens up the valved openings 622. To cool air in the inside space 618, one or more cooling units may be used. In some embodiments, the cooling units may be evaporative coolers. The cooled air is drawn from the inside space 618 through the rack-mounted units and installed in the rack 608; the heated air is expelled to the interior space 616. Heated air enters the attic space 620 through the connector 612 and is re-circulated to the inside space 618 through the valved openings 622 coupled to the ceiling 610. In some embodiments, one or more fans may be used to exhaust the heated air out of the enclosure 606 to the attic space 620 and re-circulate the air to the inside space 618.

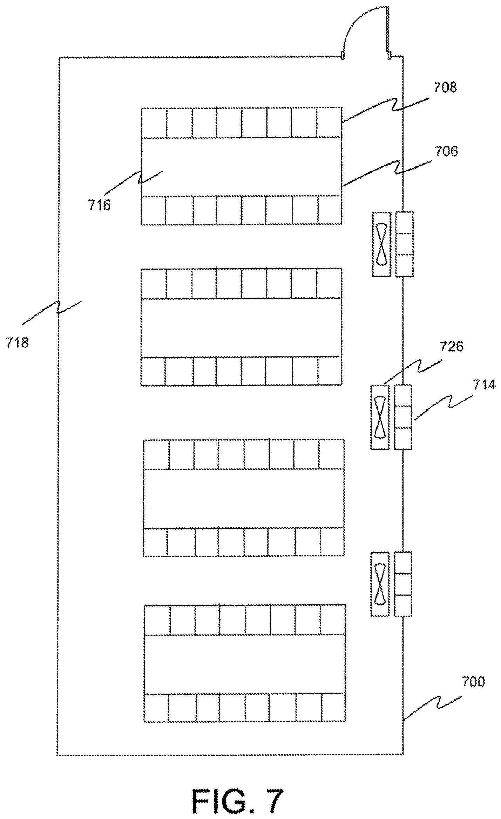

FIG. 7 illustrates a top view of an example cooling system. The lateral walls 700 and a ceiling or roof define an inside space 718. An enclosure 706 defines an interior space 716. The enclosure may be connected to one or more racks 708 in a substantially sealed manner. One or more rack-mounted units each comprising one or more cooling fans are installed in the rack 708. One or more valved openings 714 on the lateral walls 700 allow outside cool air to enter the inside space 718. The cool air is drawn from the inside space by the cooling fans mounted internally within the rack-mounted units installed in the server racks, and the heated air is ejected to the interior space 716. In some embodiments, one or more air handling units 726 may draw external cool air to the inside space 718. In one embodiment, the cooling system measures 60 feet wide, 255 feet long, and 16 feet high. Four enclosures are installed in the cooling system. Eight racks are connected to each enclosure on each side in a substantially sealed manner. Each rack comprises 16 IU servers. The lateral walls, the ceiling, the roof, and the enclosures may be pre-manufactured and installed on the construction site of the data center. Comparing with other data center designs, the example cooling system may easier to install and more efficient to operate.

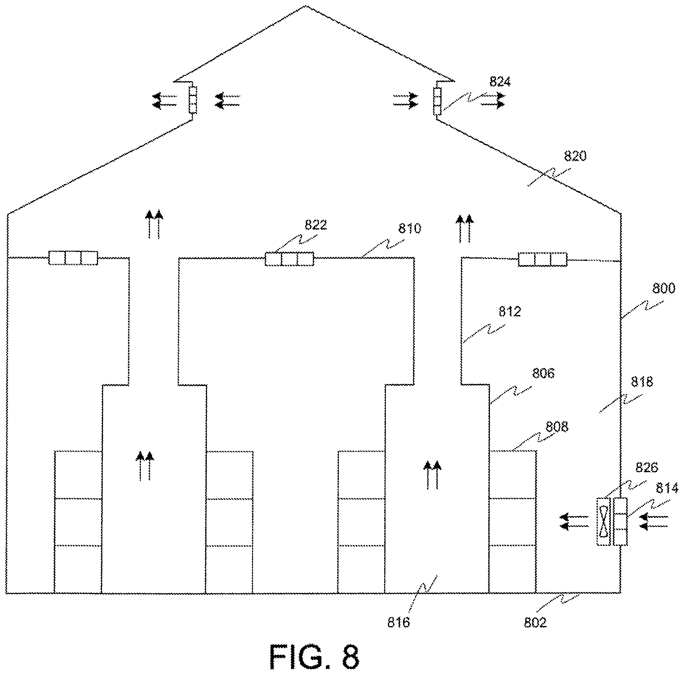

FIG. 8 illustrates another example server cooling system comprising lateral walls 800, a floor 802, a roof 804, an enclosure 806, a server rack 808, and a ceiling 810. The lateral walls 800, the floor 802 and the ceiling 810 define an inside space 818. The roof 804 and the ceiling 810 define an attic space 820. One or more valved openings 822 are coupled to the ceiling 810. There may be valved openings 824 on the roof 804 and valved openings 814 on the lateral walls 800. The example server cooling system in FIG. 8 is similar to the one in FIG. 2 except that a gable roof 804 is used instead of a single-sloped roof 204. A gabled roof may provide better air circulation in the attic space 818. However, the cost of building a gable roof may be higher than that of building a single-sloped roof.

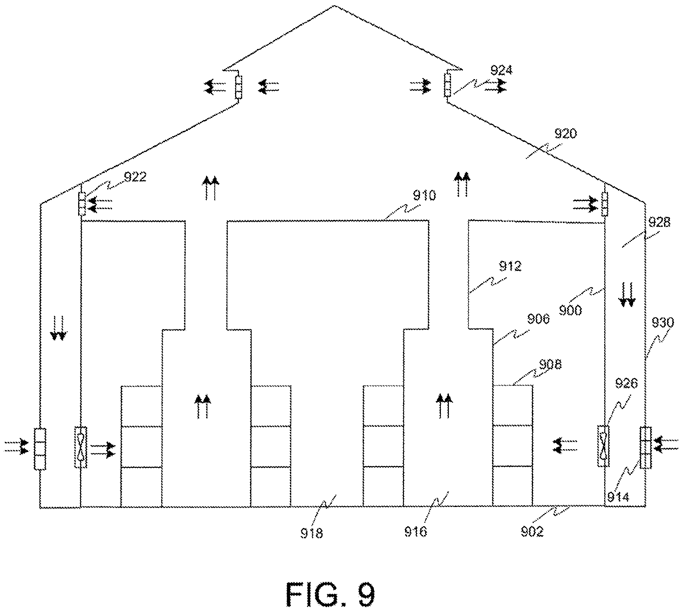

FIG. 9 illustrates another example server cooling system comprising lateral walls 900, a floor 902, a roof 904, an enclosure 906, a server rack 908, a ceiling 910, and outside walls 930. The example server cooling system in FIG. 9 is similar to the one in FIG. 8 except that the roof 904, the floor 902, the lateral walls 900, and the outside walls 930 define a mixing space 928. The lateral walls 900, the floor 902 and the ceiling 910 define an inside space 918. The roof 904 and the ceiling 910 define an attic space 920. In some embodiments, outside cool air may be drawn into the mixing space 928 through valved openings 914 on the outside walls 930. The cool air is drawn to the inside space 918 by one or more air handling units 926 coupled to the lateral walls 900. One or more rack-mounted units each comprising a cooling fan are installed in the rack 908. The cooling fans mounted internally within the rack-mounted units draw cooling air from the inside space 918 through the rack-mounted units and eject heated air to the interior space 916. The heated air enters the attic space 920 through one or more connectors 912 which operably connect the interior space 916 to the attic space 920. In some embodiments, the heated air in the attic space 920 is exhausted to the outside through one or more valved openings 924. In other embodiments, the heated air is drawn to the mixing space 928 through one or more valved openings 922 and is mixed with the outside cool air. In yet other embodiments, the valved openings 914, 922, and 924 may be operably connected to a control system which is operable to selectively activate each valved openings. When the external air is not suitable to be introduced to the inside space 918. the control system closes valved openings 914 and 924 and opens valved openings 922. Heated air in the attic space 920 is re-circulated to the mixing space 928 and is re-circulated to the inside space 918. In other embodiments, the control system monitors the temperature in the inside space 918, the attic space 920, the mixing space 928, and the temperature outside. When the difference in temper among the observed temperatures reaches one or more threshold values or other dynamic or predetermined levels, the control system may selectively open or dose each valved opening. To cool the air in the inside space, one or more cooling units may be used. In some embodiments, the cooling units are installed within the mixing space 928. In other embodiments, the cooling units are installed within the inside space 918. In one embodiment, the cooling units are evaporative coolers.

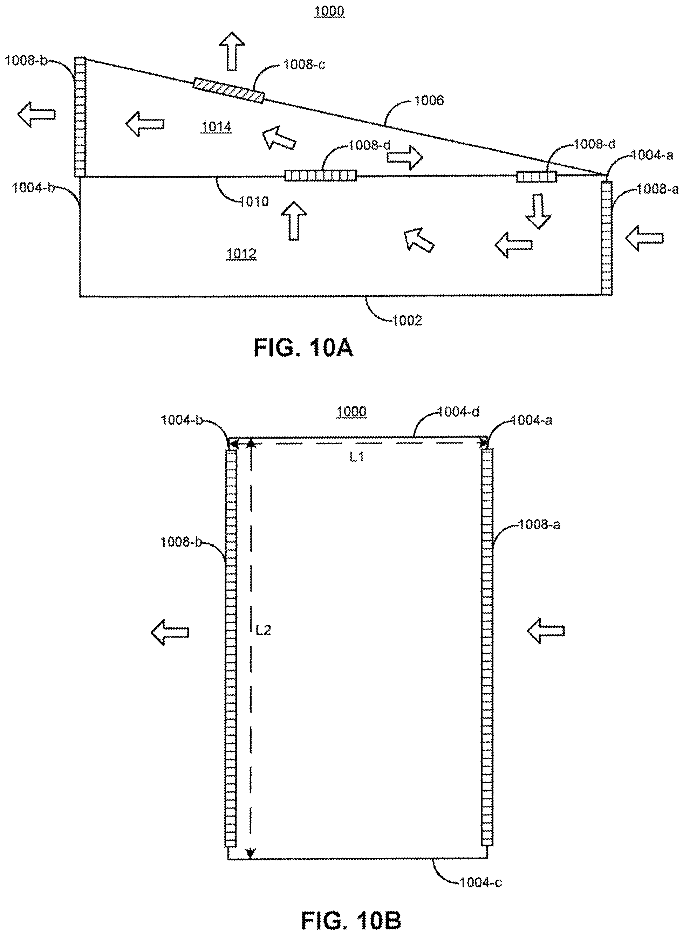

FIGS. 10A and 10B illustrate an example of an air handler building structure 1000, including a floor 1002, a plurality of lateral walls 1004, and a roof 1006. In this example, the building structure 1000 may be pre-manufactured in a factory and assembled on the construction site where a data center is to be built. As describe before, pre-manufactured units may significantly reduce the cost of the building structure 1000. One of the cost advantages of the air handler building structure 1000 for a server cooling system is the convenience and low cost of pre-manufacture parts of the system and the case of installation of pre-manufactured parts in a data center. The material of the building structure 1000 includes, but is not limited to, steel, composite material, carbon material, or any other suitable material.

The floor 1002 in this example is a non-ratsed floor, which has a relative low initial construction cost compared with a raised floor. It is understood that raised floor may be partially or completely used in the building structure 1000 in other examples. The plurality of lateral walls 1004 include a lower lateral wall 1004-a and an upper lateral wall 1004-b opposing to each other having different respective heights determined in accordance with a ratio. As shown in FIG. 10B. which is the top-view of the building structure 1000, the plurality of lateral walls 1004 may also include two other lateral walls 1004-c, 1004-d substantially perpendicular to the lower and upper lateral walls 1004-a, 1004-b. The roof 1006 may be constructed in accordance with a pitch consistent with the ratio associated with the lower and upper lateral walls 1004-a, 1004-b. In other words, the roof 1006 is a sloped roof with a pitch of 1:x, where x is substantially larger than one, so that snow builds up and melts on the roof 1006, with the heat from the interior of the building structure 1000 accelerates the snow-melting process. In one example, x equals to 6 (e.g., the pitch may be 2:12). In this example, the roof 1006 is a single-sloped roof (also known as a shed roof). It is understood that, in other examples, such as in FIGS. 8 and 9, the roof 1006 may be a gable roof or any other suitable type of roof.

One or more openings 1008, such as valved openings, may be located on different parts of the building structure 1000, such as on one or more lateral walls 1004 and the roof 1006. In this example, the lower lateral wall 1004-a has one or more openings 1008-a through which outside natural air may enter the building structure 1000. In one example, the lower lateral wall 1004-a may be substantially louvered to facilitate the outside natural air to enter the building structure 1000. In this example, the upper lateral wall 1004-b may have one or more openings 1008-b through which air in the building structure 1000 can exit. In one example, a portion of the upper lateral wall 1004-b that is above the height of the lower lateral wall 1004-a may be substantially louvered to allow air to exit the building structure 1000. Optionally, the roof 1006 may also include one or more openings 1008-c through which air in the building structure 1000 can exit. It is understood that, although FIG. 10A shows openings 1008-b, 1008-c on both the upper lateral wall 1004-b and the roof 1006, this configuration may not be necessary in other examples. As long as there are openings above the height of the openings 1008-a on the lower lateral wall 1004-a, air in the building structure 1000 can exit the building structure 1000 via natural convection.

Referring now to FIG. 10B, a first dimension L1 along a first direction is defined between the lower and upper lateral walls 1004-a, 1004-b, and a second dimension L2 along a second direction is defined perpendicular to the first direction, in this example, between the other two lateral walls 1004-c, 1004-d. As shown in FIG. 10B, L1 is smaller than L2. The relative length of L1 and L2 is designed such that the building structure 1000 provides access to outside natural air via the one or more openings 1008-a on the lower lateral wall 1004-a by increasing the area-volume-ratio of the building structure 1000. In one example, L2 may be twice of L1. Accordingly, the shape of the building structure 1000 allows air within the building structure 1000 to rise via natural convection. In other words, the building structure 1000 is designed to take advantage of the warm air's tendency to rise to achieve "free cooling." This natural "drafting" enhances the mechanically induced movement of air and therefore reduces the overall power for cooling. With the design in this example, the building structure 1000 itself serves well as an air handler even without the traditional mechanical cooling system (i.e., by "free cooling").

As shown in FIG. 10A, the building structure 1000 may include a ceiling 1010 that divides the interior of the building structure 1000 into a first space 1012 and a second space 1014. In this example, the first space 1012, which may be used for installing servers of a data center, is defined between the floor 1002 and the ceiling 1010: the second space 1014, as an attic space, is defined between the ceiling 1010 and the roof 1006. The ceiling 1010 may have one or more openings 1008-d located at different regions of the ceiling 1010. In this example, at least one opening 1008-d is located near the openings 1008-a on the lower lateral wall 1004-a where the outside natural air enters the building structure 1000. With such configuration, the outside natural air enters the first space 1012 through the openings 1008-a on the lower lateral wall 1004-a and exits the first space 1012, by natural convection, through the openings 1008-d on the ceiling 1010 to enter the second space 1014. The air in the second space 1014 then exits, by natural convection, through the openings 1008-b on the portion of the upper lateral wall 1004-b above the ceiling 1010 and/or the openings 1008-c on the roof 1006. The air in the second space 1014 may also enter the first space 1012 through the openings 1008-d on the ceiling 1010 near the lower lateral walt 1004-a and may be mixed with the natural air entered the first space 1012.

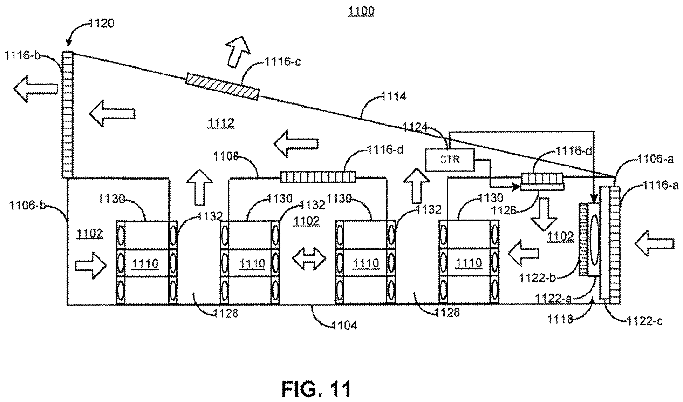

FIG. 11 illustrates an example of a server cooling system 1100. In this example, the system 1100 includes a first space 1102 defined by a floor 1104, one or more lateral walls 1106, and a ceiling 1108. A plurality of servers 1110 may be installed in the first space 1102. The system 1100, in this example, also includes a second space 1112, as an attic space, defined by the ceiling 1103 and a roof 1114, One or more openings 1116, such as valved openings, may be located on at least one of the ceiling 1108, the roof 1114, and at least one of the lateral waits 1106. In this example, the first lateral wall (e.g., a lower lateral wall) 1106-a has one or more openings 1116-a; the ceiling 1108 has one or more openings 1116-d, including at least one opening 1116-d near the lower lateral wall 1106-a; a portion of a second lateral wall (e.g., an upper lateral wall) 1106-b above the ceiling 1108 (in the second space 1112) and/or the roof 1114 include one or more openings 1116-b, 1116-c, respectively. The openings 1116, as described above, are used to realize the movement of air between the outside space, the first space 1102, and the second space 1112.

In this example, the system 1100 includes an air inlet 1118 coupled with the first lateral wall 1106-a and operable to allow outside natural air to enter the first space 1102. The air inlet 1118, in this example, includes one or more louvered openings 1116-a on the first lateral wall 1106-a. The system 1100 may also include an air outlet 1120 coupled with the second lateral wall 1106-b and operable to allow air in the second space 1112 to exit. The air outlet 1120, in this example, includes one or more louvered openings 1116-b on the second lateral wall 1106-b. The system 1100 may further include one or more air-handling units 1122 coupled with the air inlet 1118 to draw the outside natural air and to provide air to the first space 1102. The air-handling units 1122 include, for example, a fan 1122-a, an evaporative cooling unit 1122-b configured to generate evaporative cooling air based on the outside natural air, and in some embodiments a filter 1122-c configured to filter the outside natural air entering the first space 1102. The fan 1122-a may be a speed controlled fan and is designed to keep air turbulence high, which helps mitigate temperature gradients and induces mixing. Optionally, the system 1100 may also include one or more uninterruptible power supply (UPS) systems utilizing kinetic stored energy.

In this example, the system 1100 also includes a control system 1124 configured to control the one or more air-handling units 1122 to provide air to the first space 1102 in accordance with temperatures measured within and outside of the first space 1102. The control system 1124 may include one or more devices such as a microprocessor, microcontroller, digital signal processor, or combinations thereof capable of executing stored instructions and operating upon stored data. Control system arrangements are well known to those having ordinary skill in the art, for example, in the form of embedded system, laptop, desktop, tablet, or server computers.

The control system 1124 may include or couple to one or more sensors (not shown) to monitor the environmental metrics such as temperature and humidity within and outside the first space 1102. For example, temperature sensors may be deployed at different locations in the first space 1102, the second space 1112, and space outside the server cooling system 1100 to provide real-time temperatures of various locations. In one example, hot aisle (hot row enclosure) temperature of the server racks in the first 1102 may be used to regulate speed controlled fans; cold aisle (cold row enclosure) temperature of the server racks in the first 1102 and outside air temperature and humidity may be used to provide an indication of outdoor and return air mixing efficiencies. Dew point sensors and/or humidity sensors may also be provided in the air inlet 1118 and the air-handling units 1122 to monitor the humility of the air entering the first space 1102. It is understood that, although the control system 1124 in FIG. 11 is installed in the second space 1112, it may be installed in other places within the server cooling system 1100 or outside the server cooling system 1100. In this example, the control system 1124 is operatively coupled to the air-handling units 1122 and other components of the server cooling system 1100, such as but not limited to an air-exchanging unit 1126, which may be coupled to the openings 1214-d on the ceiling 1108 near the first lateral wall 1106-a and may be configured to draw air from the second space 1112 into the first space 1102 in order to mix with the outside natural air entering the first space 1102. The connections between the control system 1124 and other components of the system 1100 may be achieved using any known wire or wireless communication techniques.

Depending on the measured temperatures within and outside of the first space 1102, the control system 1124 may control the operations of the air-handling units 1122 in conjunction with other components of the server cooling system 1100 in, for example three different working modes at three different temperature ranges.

In a first range, which is an optimal working temperature range for the servers 1110, the control system 1124 may control the air-handling units 1122 in conjunction with the air-exchanging unit 1126 to directly provide the outside natural air into the first space 1102 to achieve the so called "free cooling." Specifically, in this mode, the control system 1124 may turn off the evaporative cooling unit 1122-b and turn on the fan 1122-a to directly draw the outside natural air into the first space 1102 without extra cooling. Optionally, the control system 1124 may also turn on the filter 1122-c to filter the incoming natural air. In this mode, the control system 1124 may further turn off the air exchanging unit 1126 to stop mixing the incoming natural air in the first space 1102 with the heated air from the second space 1112, which may increase the temperature in the first space 1102. In one example, the first range is substantially between 70 °F and 85 °F.

In a second range, which is lower than the first range, the control system 1124 may control the air-handling units 1122 in conjunction with the air-exchanging unit 1126 to provide air to the first space 1102 based on a mixed outside natural air and air exhausted from the servers 1110 through one or more openings 1116-d on the ceiling 1108 near the air inlet 1118. Specifically, in this mode, the control system 1124 may turn off the evaporative cooling unit 1122-b and turn on the fan 1122-a to draw the outside natural air into the first space 1102. Optionally, the control system 1124 may turn on the filter 1122-c to filter the incoming natural air. In this mode, the control system 1124 may turn on the air-exchanging unit 1126 to draw the air exhausted through the servers 1110 into the second space 1112 to the first space 1102 in order to heat up the incoming natural air in the first space 1102. In this example, the air-exchanging unit 1126 may include a damper, a return fan coupled with the openings 1106-d, and a recirculation fan to help blend the mixing air, preventing any temperature or humidity gradients. In one example, the second range is about below 70°F.

In a third range, which is higher than the first range, the control system 1124 may control the air-handling units 1122 in conjunction with the air-exchanging unit 1126 to provide evaporative cooling air to the first space 1102 based on the outside natural air drawn from the air inlet 1118 through saturated media. Specifically, in this mode, the control system 1124 may turn on both the evaporative cooling unit 1122-b and the fan 1122-a to draw the outside natural air into the first space 1102 and cool it down by evaporative cooling. Optionally, the control system 1124 may turn on the filter 1122-c to filter the incoming natural air. In this mode, the control system 1124 may turn off the air-exchanging unit 1126 to stop mixing the incoming natural air in the first space 1102 with the heated air from the second space 1112. Optionally, a dew point sensor may be used in conjunction with the evaporative media of the evaporative cooling unit 1122-b to ensure additional moisture is not added to already saturated air. In one example, the second range is substantially between 85 °F and 110 °F.

It is noted that in any temperature range, the control system 1124 may be further configured to selectively activate one or more of the openings 1116-a on the first lateral wall 1106-a to control the amount of the outside natural air drawn into the first space 1102 based on the temperatures measured within and outside of the first place 1102. In addition, when the measured temperature is above 110 °F, additional mechanical cooling units and air-conditioning units may be turned on to provide extra cooling.

The first space 1102 of the system 1100 may further include at least one substantially enclosed interior space 1128 engaging the ceiling 1108 and open to the second space 1112 and at least one rack 1130 engaging the interior space 1128 in a substantially sealed manner and having the plurality of servers 1110 mounted thereon. The interior space 1128 may be defined by an enclosure having a frame, panels, doors, and rack ports. The enclosure of the interior space 1128 may be made of a variety of materials such as steel, composite materials, or carbon materials. The enclosure creates a housing defining the interior space 1128 that is substantially sealed from the first space 1102. The enclosure of the interior space 1128 includes at least one rack port that allows one or more servers 1110 installed in the racks 1130 to interface with the interior space 1128. One or more edges of the rack port may include a gasket or other component that contacts the rack 1130 and forms a substantially sealed interface. The rack 1130 may be removably connected to the enclosure of the interior space 1128 through the rack port in a substantially sealed manner.

In this example, one or more servers 1110 are installed in the racks 1130 such that respective front faces of the servers 1110 interface with the first space 1102, and that respective back faces of the servers 1110 interface with the interior space 1128. In this example, each rack-mounted server 1110 may include one or more fans 1132 therein operable to draw air from the first space 1102 through its front face and expel heated air to the interior space 1128 through its back face.

The server cooling system 1100 can maintain a properly mixed server supply air in an optimal working temperature range, for example between 70 °F and 85 °F and in a non-condensing relative humidity range, for example below 85%.

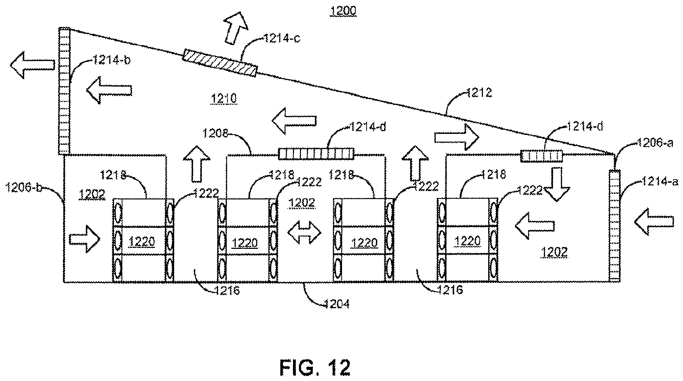

FIG. 12 illustrates another example of a server cooling system 1200. The system 1200 includes a first space 1202 defined by a floor 1204, a plurality of lateral walls 1206, and a ceiling 1208, and a second space 1210 defined by the ceiling 1208 and a sloped roof 1212 constructed in accordance with a pitch. One or more openings 1214, such as valved openings, may be located on at least one of the roof 1212, the ceiling 1208, and at least one of the lateral walls 1206, that enable outside natural air to enter the first space 1202 and air in the second space 1210 to exit by natural convection. The system 1200 may also include at least one interior space 1216 inside the first space 1202, that is substantially enclosed and engaging the ceiling 1208, and at least one rack 1218 engaging the interior space 1216 in a substantially sealed manner and having a plurality of servers 1220 mounted thereon. In this example, one or more servers 1220 are installed in the racks 1218 such that respective front faces of the servers 1220 interface with the first space 1202, and that respective back faces of the servers 1220 interface with the interior space 1216. In this example, each rack-mounted server 1220 may include one or more fans 1222 therein operable to draw air from the first space 1202 through its front face and expel heated air to the interior space 1216 through its back face.

The building structure in FIG. 12 is similar to that in FIGS. 10A and 10B, which is designed to take advantage of natural convention to enhance the mechanically induced movement of air and therefore reduce the overall energy necessary for cooling the servers. The example server cooling system 1200 in FIG.12 is similar to that in FIG. 11 except that system 1200 does not include the external air-handling units and air exchanging units such as fans and evaporative cooling unit. The air circulation is induced by the internal fans 1222 of the servers 1220 and the natural convection enhanced by the special designed building structure. Accordingly, the total energy consumption of the system 1200 in FIG. 12 may be further reduced compared with the system 1100 in FIG. 11.

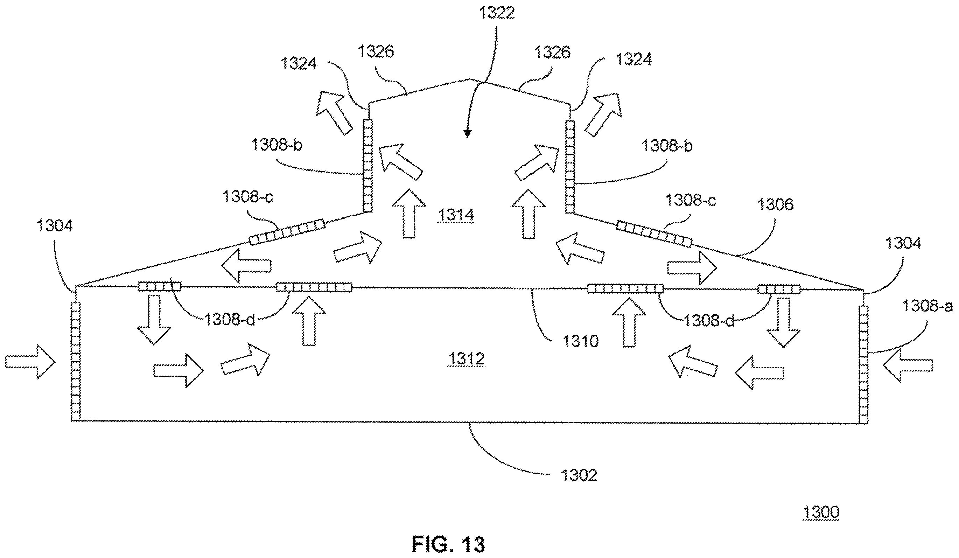

FIG. 13 illustrates a cross-section of another exemplary air handler building structure 1300. The air handler building structure 1300 is similar to air handler building structure 1000, including a floor 1302, a plurality of lateral walls 1304. The floor 1302 in this exemplary embodiment can be a non-raised floor. It is understood that a raised floor may be partially or completely used in the building structure 1300 in other embodiments.

The air handler building structure 1300 has two roof portions 1306, symmetrically placed on either side of a protruding portion 1322. The protruding portion 1307 is higher than the highest part of the roof portions 1306, and placed above the center of the building in cross-section. The roof portions 1306, and the protruding portion 1322 extend along the air handler building structure 1300 in a direction perpendicular to the cross-section in FIG. 13.

The protruding portion 1322 has lateral walls 1324 and roof portions 1326. The lateral walls 1304, 1324 and the roof portions 1306, 1326 are constructed in a similar manner to lateral walls 1004 and the roof portions 1006.

The roof portions 1306, like the roof portions 1006 may be constructed in accordance with a pitch of 1:x, where x is substantially larger than one, so that snow builds up and melts on the roof 1006, with the heat from the interior of the building structure 1300 accelerating the snow-melting process. In one example, x equals to 6.

One or more openings 1308, such as valved openings, may be located on different parts of the building structure 1300, such as on one or more lateral walls 1304 and the roof portions 1306. In this example, the lower lateral wall 1304-a has one or more openings 1308-a through which outside natural air may enter the building structure 1300. In one example, the lateral wall 1304 may be substantially louvered to facilitate the outside natural air to enter the building structure 1300. In this example, the lateral walls 1324 of the protruding portion 1312 may have one or more openings 1308-b through which air in the building structure 1300 can exit. In one example, a portion of the lateral walls 1324 are above the height of the lateral wall 1304 may be substantially louvered to allow air to exit the building structure 1300. Optionally, the roof portions 1306 may also include one or more openings 1308-c through which air in the building structure 1300 can exit. It is understood that, although FIG. 13 shows openings 1308-c on the roof portion 1306, this configuration may not be necessary in other examples. As long as there are openings 1308 above the height of the openings 1308-a on the lateral wall 1304, air in the building structure 1300 can exit the building structure 1300 via natural convection.

The additional height of the one or more openings 1308-b on the lateral walls 1324 above the height of the openings 1308-a on the lateral wall 1304 increases the natural convection in the building structure 1300 over that of the building structure 1000.

As shown in FIG. 13, the building structure 1300 may include a ceiling 1310 that divides the interior of the building structure 1300 into a first space 1312 and a second space 1314. In this example, the first space 1312, which may be used for installing servers of a data center, is defined between the floor 1302 and the ceiling 1310; the second space 1314, as an attic space, is defined between the ceiling 1310 and the roof 1306 and the protruding portion 1322. The ceiling 1310 may have one or more openings 1308-d located at different regions of the ceiling 1310. In this example, at least one opening 1308-d is located near the openings 1308-a on the lower lateral wall 1304-a where the outside natural air enters the building structure 1300. With such configuration, the outside natural air enters the first space 1312 through the openings 1308-a on the lateral wall 1304 and exits the first space 1312, by natural convection, through the openings 1308-d on the ceiling 1310 to enter the second space 1314. The air in the second space 1314 then exits, by natural convection, through the openings 1308-b on the protruding portion 1322 above the ceiling 1310 and/or the openings 1308-c on the roof portion 1306. The air in the second space 1314 may also enter the first space 1312 through the openings 1308-d on the ceiling 1310 near the lateral wall 1304-a and may be mixed with the natural air entered into the first space 1312.

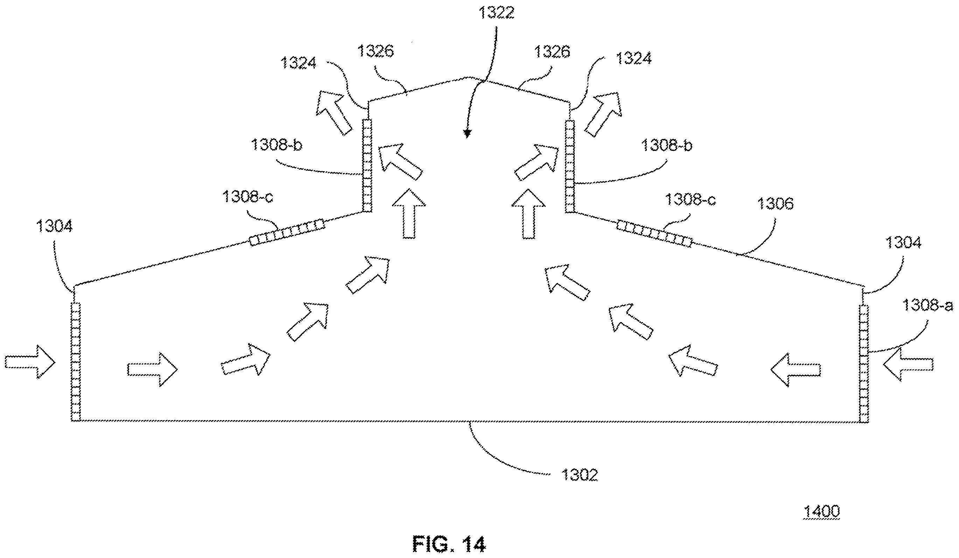

FIG. 14 illustrates a cross-section of an other example of an air handler building structure 1400 that is similar to the building structure 1300 but without the ceiling 1310 and opening 1308-d. (other features have the same labels as in FIG. 13) The natural convection draws air through openings 1308-a which rises through the building structure 1400 and out through openings 1308-b.

The various examples of the building structures and server cooling systems disclosed herein can achieve an almost 100% uptime availability, for example, 99.98% uptime availability for a data center facility, for example, having a 9.0 MW critical load. The various examples of the building structures and server cooling systems disclosed herein can allow for free cooling, for example, 99% of the year via the building structures' unique shape and orientation, as well as server physical configuration. Also, the various examples of the building structures and server cooling systems disclosed herein can achieve about 2% annualized "cost to cool" with evaporative cooling, where "cost to cool" is the energy (kW) expended to remove the heat generated by the data center load as a percentage of the data center load itself. Further, the various examples of the building structures and server cooling systems disclosed herein can save, for example, about 36 million gallons of water used for cooling compared with conventional water-cooled chiller plant designs with comparable IT loads. The various examples of the building structures and server cooling systems disclosed herein can achieve high efficiency to a target power usage effectiveness (PUE) of, for example, less than about 1.11, such as 1.08. Moreover, the various examples of the building structures and server cooling systems disclosed herein can achieve about 40% reduction in data center electricity consumption relative to industry-typical legacy data centers. For example, for a data center with a 9 MW of critical load, various examples of the building structures and server cooling systems disclosed herein can reduce energy consumption of 8.6 to 18.9 million KWh per year compared with conventional collocated facilities. Because water-cooled chiller may not be required in the exemplary server cooling systems disclosed herein, there may be zero data center-related wastewater generated by the server cooling systems, which equals to a reduction of about 8 million gallons of sewer discharge per year compared with conventional water-cooled chiller plant design. Furthermore, the various examples of the building structures and server cooling systems disclosed herein can reduce the construction cost compared with traditional designs, for example, to no more than $ 5M per MW and reduce the construction time to, for example, less than 6 months. In one example, the various examples of the building structures and server cooling systems disclosed herein can maintain the following room environmental requirements: room temperature of 55°F - 90°F. no higher than 85% non-condensing relative humidity, pressure of $\pm 0.11$ inches $H_2O$, and 5.4°F per hour of rate of temperature change. The various examples of the building structures and server cooling systems disclosed herein can withstand 100-year temperature and humidity conditions and extremely low winter temperatures while maintaining server room environmental requirements.

EXEMPLARY RESULTS

TABLE 1

|  | 2005 | 2006 | 2006 | 2007 | 2010 |
|---|---|---|---|---|---|
| **Type of System** | Standard CRAC: no economizing, DX cooling system | Water conted site built chiller plant; standard CRAC; no economizing | Air cooled chiller plant; AHU with outside economizing | Modular, tuned chiller plant; next-gen AHU with outside air economizing | Yahoo! Compute Coop |
| Site Example | Yahoo! colocation site in Santa Clara, CA | Yahoo! colocation site in Santa Clara, CA | Yahoo! existing data center facility in Wenatchae, WA | Quincy, WA Phase 1 | Lockport, NY |
| KW per ton AHU | 0.53 | 0.50 | 0.40 | 0.35 | 0.10 |

(continued)

| | 2005 | 2006 | 2006 | 2007 | 2010 |
|---|---|---|---|---|---|
| KW per ton CHW | NA | 0.75 | 1.19 | 0.88 | 0. 03 |
| KW per ton CHW during free cooling | | | 0.10 | 0.06 | 0 |
| KW per for DX | 1. 39 | NA | NA | NA | NA |
| EXAMPLE electro/ mechanical load KW | 5,000 | 5,000 | 5,000 | 5,000 | 5.000 |
| Tonnage requirement | 1.420 | 1,420 | 1,420 | 1,420 | 1,420 |
| KW AHU (max) | 710 | 710 | 589 | 497 | 142 |
| KW AHU best (free cooling) | N/A | N/A | 142 | 85 | 0 |
| KW AHU average | 710 | 710 | 355 | 291 | 71 |
| KW heat removal max (OX or CHW) | 1,988 | 1,085 | 1,833 | 865 | 42 |
| KW heat removal best best (free cooling) | - | - | 142.05 | 89.23 | 0 |
| KW best removal average | 1,980 | 1,085 | 588 | 588 | 21 |
| **Total cooling load KW per MW DC load** | **2.670** | **1,775** | **1.313** | **359** | **92** |
| **% of Total Cooling** | **53%** | **36%** | **26%** | **17%** | **2%** |

TABLE 1 is a breakdown of the progression of cooling efficiency over time by using at least some of the examples of the building structures and server cooling systems disclosed herein. In TABLE 1, AHU represents air handling units, CHW represents chilled water, and DX represents direct expansion. For example, by applying at least some of the examples of the building structures and server cooling systems disclosed herein, the average power used in AHU has been reduced from 710 KW to 71 KW. As another example, using at least some of the exemplary disclosed embodiments, the percentage of the total cooling have been reduced over the years from 53% in 2005, as typical industry standard, to only 2% in the most recent experiment via YAHOO!'s Compute Coop in 2010. This represents a substantial improvement.

TABLE 2

| | Yahoo! Colocation Data Center Facility - Santa Clara CA (2006) | Yahoo! Data Center Facility - Quincy, WA (2007) | Yahoo! Compute Coop (YCC) Data Center Facility - Lockport NY (2010) |
|---|---|---|---|
| True server load (watts): equivalent performance - 2 CPU cores, 4GB RAM, 1 80 GB HD | 140 | 89 | 89 |
| Power supply efficiency loss (watts) | 215 | 93 | 93 |
| Dist / server voltage transformation loss (watts) | 222 | - | - |
| UPS efficiency loss (watts) | 252 | 99 | 97 |
| Medium voltage transformation loss (watts) | 257 | 101 | 99 |
| Total power per example server (watts) | 257 | 101 | 99 |
| KW cost to power 25.000 servers (without cooling) | 6,438 | 2.529 | 2.498 |
| KW cost to pool servers | 2,285 | 434 | 48 |
| **Total KW cost for 25,000 servers** | **8,722** | **2,963** | **2.535** |
| **Total KW power savings versus Santa Clara CoLo** | | **5,759** | **6,187** |
| **PUE** | **1.62** | **1.27** | **1.08** |

TABLE 2 is a breakdown of the progression of electrical efficiency over time by using at least some of the examples of the building structures and server cooling systems disclosed herein. In TABLE 2, PUE represents power usage effectiveness, which is obtained by measuring the system utility power input and the critical power consumption as close as possible to the server loads. This information may be read and collected from the installed Electrical Power Monitoring System (EPMS) using power circuit monitors. Since all data centers in TABLE 2 may extensively utilize outside air cooling methods, data may be collected on a monthly basis and annualized to account for variables such as weather, operating hours, etc.. PUE can be calculated using the following:

$$PUE = \frac{Total\ Facility\ Power}{IT\ Equipment\ Power}$$

where, IT Equipment Energy is the comprehensive energy use associated with all of the IT equipment such as computer, storage and network equipment along with supplemental equipment; Total Facility Energy is all facility energy use including IT equipment energy, electrical distribution losses, cooling system energy, fuel usage, and other miscellaneous energy use.

TABLE 2 shows that YAHOO! Lockport, NY facility has a 70% improvement over the YAHOO! Santa Clara, CA co-location facility when improvements in all components in electrical efficiency path are included. For example, by applying at least some of the examples of the building structures and server cooling systems disclosed herein, PUE has been further reduced from 1.62 to 1.08, compared with an industry average of 2.0.

TABLE 3

| | Yahoo! Colocation Data Center Facility-Santa Clara CA | Yahoo! Data Center Facility-Quincy WA | Yahoo! Compute Coop (YCC) Data Center Facility-Lockport, NY |
|---|---|---|---|
| PUE | 1.52 | 1.27 | 1.08 |
| Relative energy savings for a 9 MW YCC plant (kWh/year) | 26,541.307 | 12,094.773 | - |
| Average annual carbon savings (tons CO$_2$) | 14,569 | 0,773 | - |

TABLE 3 shows the energy and carbon savings utilizing at least some of the examples of the building structures and server cooling systems disclosed herein. In addition, minimized use of evaporative cooling as compared to standard cooling methods may yield a 99% reduction in water use at the facility (and a corresponding reduction in wastewater outflow) as compared to a traditional data center that uses water cooled chillers. The carbon savings below assumes an average U.S. carbon intensity of 0.56 tons CO$_2$/MWh. In other examples, the actual carbon reductions may be much lower by virtue of how clean electricity is in all three sites (0.31 tons CO$_2$/MWh for Santa Clara, and close to zero for both WA state and NY state).

Two example YAHOO! data center facilities disclosed in TABLES 1-3 are described in details below.

YAHOO! Data Center Facility - WA

Site Description: The existing installation at Wenatchee has proven to be the most efficient YAHOO! data center prior to 2010. Located in central Washington, the site was selected for its climate, with the existing building optimized to take advantage of outside air economization. Air handling units (AHU) discharge into a traditional raised floor plenum, distributing supply air to the servers.
Installation Date: 2006
Electrical: 4.8 MW, N+1 critical infrastructure with 4,800 KW static battery UPS and 4 x 2 MW diesel generator back up.
Cooling System: Air Cooled Chillers and AHUs with outside air economizing.
Designed Target PUE: 1.25.

YAHOO! Compute Coop (YCC) Data Center Facility - Lockport, NY

Site Description: The innovative design and installation of the YAHOO! Compute Coop at Lockport is the most efficient of all YAHOO! data centers to date, Located in Lockport, NY, the greenfield site was selected for its cold climate; its unique design exclusively incorporates outside air economization, significantly reducing supply fan horsepower.
Installation Date: 2010.
Electrical: 9 MW, N+1 critical infrastructure with line interactive UPS systems using kinetic stored energy and diesel generator backup. Primary UPS systems are deployed in 200 KW modules, allowing systems to be taken offline when not in use.
Cooling System: YAHOO! Compute Coop integrated building system cooling with evaporative cooling.
Designed Target PUE: 1.08 - 1.11.

The deployment of at least some of the examples of the building structures and server cooling systems disclosed herein has evidence to prove their effectiveness. Innovative building structures and server cooling systems disclosed herein can reduce risk aversion within the data center industry (both data center designers and IT equipment manufacturers) for other innovations that relate to free cooling, chiller-less data centers, and broader temperature ranges - as well as experimenting with designing data centers with closer attention to maximizing the use of local climate conditions.

The present invention has been explained with reference to specific embodiments. For example, while embodiments of the present invention have been described with reference to specific components and configurations, those skilled in the art will appreciate that different combination of components and configurations may also be used. For example, raised subfloors, CRAC units, water chiller, or humidity control units may be used in some embodiments. Seismic control devices and electrical and communication cable management devices may also be used in some embodiments. Other embodiments will be evident to those of ordinary skill in the art. It is therefore not intended that the present invention be limited, except as indicated by the appended claims.

Various examples are set out in the following numbered paragraphs (NPs):

NP 1. An air handler budding structure, comprising:

a floor;
a plurality of lateral walls, including a lower and an upper lateral walls opposing to each other having different respective heights determined in accordance with a ratio;
a roof with a pitch consistent with the ratio associated with the lower and upper lateral walls; and
one or more openings located on at least one of the roof and at least one of the lateral walls, wherein
the shape of the building structure allows air within the building structure to rise via natural convection, and
a first dimension along a first direction defined between the lower and upper lateral walls relative to a second dimension along a second direction perpendicular to the first direction such that the building structure provides access to outside natural air via one or more openings on the lower lateral wall.

NP 2. The building structure of NP 1, further comprising:

a ceiling having one or more openings;
a first space defined between the floor and the ceiling; and
a second space defined between the ceiling and the roof, wherein
the outside natural air enters the first space through the one or more openings on the lower lateral wall, and
air in the first space exits, via natural convection, through the one or more openings on the ceiling.

NP 3. The building structure of NP 2, wherein air in the second space exits, via natural 1 convection, through the one or more openings located on at least one of the roof and at least one of the lateral walls above the ceiling.

NP 4. The building structure of NP 2, wherein air in the second space enters the first space via one or more openings on the ceiling near the lower lateral wall and is mixed with the outside natural air entered into the first space.

NP 5. The building structure of NP 1, wherein the second dimension is greater than the first dimension.

NP 6. The building structure of NP 1, wherein the ratio of the second dimension to the first dimension is two.

NP 7. The building structure of NP 1, wherein the pitch is 1:x, where x is substantially larger than one, yielding a sloped roof that allows snow to build up and melt and heat from interior of the building structure accelerates the snow-melting process.

NP 8. The building structure of NP 7, wherein x is 6.

NP 9. The building structure of NP 1, wherein
the lower lateral wall is substantially louvered to allow the outside natural air to enter the building structure, and
the upper lateral wall has a portion above the height of the lower lateral wall substantially louvered to allow air to exit the building structure.

NP 10. The building structure of NP 1, wherein the floor is a non-raised floor.

NP 11. The building structure of NP 1, wherein the roof is one of a single-sloped roof and a gable roof.

NP 12. A server cooling system, comprising:

a first space defined by a floor, one or more lateral walls, and a ceiling, having a. plurality of servers installed therein;
a second space defined by the ceiling and a roof;
one or more openings located on at least one of the ceiling, the roof, and at least one of the one or more lateral walls;
an air inlet coupled with a first lateral wall and operable to allow outside natural air to enter;
one or more air-handling units coupled with the air inlet to draw the outside natural air and to provide air to the first space;
an air outlet coupled with a second lateral wall and operable to allow air in the second space to exit; and

a control system configured to control the one or more air-handling units to provide air to the first space in accordance with temperatures measured within and outside of the first space.

NP 13. The system of NP 12, wherein the control system controls the one or more air-handling units to provide the outside natural air to the first space when the temperatures measured within and outside of the first place is within a first range.

NP 14. The system of NP 13, wherein when the temperatures measured within and outside of the first place is within a second range lower than the first range, the control system controls the one or more air-handling units to provide air to the first space based on a mixed outside natural air and air exhausted from the plurality of servers through one or more openings on the ceiling near the air inlet.

NP 15. The system of NP 14, wherein when the temperatures measured within and outside of the first place is within a third range higher than the first range, the control system controls the one or more air-handling units to provide evaporative cooling air to the first space based on the outside natural air drawn from the air inlet through saturated media.

NP 16. The system of NP 15, wherein
the first range is substantially between 70°F and 85°F,
the second range is about below 70°F, and
the third range is substantially between 85°F and 110°F.

NP 17. The system of NP 12, wherein the air inlet includes one or more louvered openings on the first lateral wall.

NP 18. The system of NP 12, wherein the air outlet includes one or more louvered openings on at least one of the roof and the second lateral wall.

NP 19. The system of NP 12, further comprising an air exchanging unit coupled to the one or more openings on the ceiling and configured to draw air from the second space into the first space in order to mix with the outside natural air entering into the first space.

NP 20. The system of NP 17, wherein the control system is further configured to selectively activate one or more of the openings on the first lateral wall to control the amount of the outside natural air drawn into the first space based on the temperatures measured within and outside of the first place.

NP 21. The system of NP 12, wherein the first space comprises:

a substantially enclosed interior space engaging the ceiling and open to the second space; and
a rack engaging the interior space in a substantially scaled manner and having the plurality of servers mounted thereon, wherein
respective front faces of the rack-mounted servers interface with the first space,
respective back faces of the rack-mounted servers interface with the interior space, and
each rack-mounted server includes one or more fans therein operable to draw air from the first space through its front face and expel heated air to the interior space through its back face.

NP 22. The system of NP 12, wherein the one or more air-handling units include:

an evaporative cooling unit configured to generate evaporative cooling air based on the outside natural air; and
a filter configured to filter the outside natural air entering the first space

NP 23, A server cooling system, comprising:

a first space defined by a floor, a plurality of lateral walls, and a ceiling;
a second space defined by the ceiling and a sloped roof constructed in accordance with a pitch;
one or more openings, located on at least one of the roof, the ceiling, and at least one of the lateral walls, that enable outside natural air to enter the first space and air in the second space to exit by natural convection;
an interior space inside the first space, that is substantially enclosed and engaging the ceiling;
a rack engaging the interior space in a substantially sealed manner and having a plurality of rack-mounted servers mounted thereon, wherein
respective front faces of the rack-mounted servers interface with the first space, respective back faces of the rack-mounted servers interface with the interior space, and
each rack-mounted server includes one or more fans installed therein operable to draw air from the first space through its front face and expel heated air to the interior space through its back face.

NP 24. The system of NP 23, wherein air in the first space exits, via natural convection, through one or more openings on the ceiling and enters the second space.

NP 25. The system of NP 23, wherein air in the second space enters the first space via one or more openings on the ceiling and is mixed with the outside natural air entered into the first space.

NP 26. The system of NP 23, wherein the pitch is 1:x, where x is substantially larger than one, yielding a sloped roof that allows snow to build up and melt and heat from the plurality of servers accelerates the snow-melting process.

NP 27. The system of NP 26, wherein x is 6.

NP 28. The system of NP 23, wherein
a first of the lateral walls is substantially louvered to allow the outside natural air to enter the first space, and
a second of the lateral walls has a portion in the second space substantially louvered to allow air to exit the second space.

NP 29. The system of NP 23, wherein the floor is a non-raised floor.

NP 30. The system of NP 23, wherein the roof is one of a single-sloped roof and a gable roof.

NP 31. An air handler building structure, comprising:

a floor;
a plurality of lateral walls;
a roof portion having opposing sides, each having a pitch;
a protruding portion extending above the roof portion; and
one or more openings located on at least one of the roof portion, at least one of the lateral walls, and the protruding portion, wherein
the shape of the building structure allows outside natural air to enter through one or more openings on at least one of the lateral walls via natural convection and exit through one or more openings on at least one of the roof portion and the protruding portion,

NP 32. The building structure of NP 31, further comprising:

a ceiling having one or more openings;
a first space defined between the floor and the ceiling; and
a second space defined between the ceiling and the roof portion and the protruding portion, wherein
outside air enters the first space through the one or more openings on one or more of the lateral walls, and
air in the first space exits, via natural convection, through one or more openings on at least one of the ceiling, the roof portion, and the protruding portion.

NP 33. The building structure of NP 32, wherein air in the second space exits, via natural convection, through one or more openings located on at least one of the roof portion and the protruding portion.

NP 34. The building structure of NP 32, wherein air in the second space enters the first space via one or more openings on the ceiling near one or more of the lateral walls and is mixed with the outside natural air entered into the first space

NP 35. The building structure of NP 31, wherein
a first dimension is defined along a first direction between a first pair of opposing lateral walls;
a second dimension is defined between a second set of opposing lateral walls aligning along a second direction perpendicular to the first direction;

the first dimension relative to the second dimension is such that: the building structure provides access to outside natural air via one or more openings on at least one of the lateral waits, wherein the second dimension is greater than the first dimension.

NP 36. The building structure of NP 32, the shape of the building structure causes the air to be drawn, from the first space, through one or more servers in the first space, via natural convection, and hot air yielded by the servers to exit from the first space to the second space.

NP 37. The building structure of NP 31, wherein the pitch is 1:x, where x is substantially larger than one, yielding a sloped roof that allows snow to build up and melt and heat from interior of the building structure accelerates the snow-metting process

NP 38. The building structure of NP 37, wherein x is 6.

NP 39. The building structure of NP 32, wherein
at least one of the lateral walls is substantially louvered to allow the outside air to enter the building structure; and
at least one of the lateral walls has a portion above the ceiling substantially louvered to allow air to exit the building structure.

NP 40. The building structure of NP 31, wherein the floor is a non-raised floor.

**Claims**

1. An air handler building structure, comprising:

   a floor;
   a plurality of lateral walls;
   a roof portion having opposing sides, each having a pitch;
   a protruding portion extending above the roof portion;
   a plurality of servers located within a space defined by the lateral walls; and
   a plurality of openings located on the roof portion, at least one of the lateral walls, and the protruding portion, that enable outside natural air to enter through one or more openings on at least one of the lateral walls via natural convection and exit through one or more openings on the roof portion and the protruding portion, such that the flow of the outside natural air cools the plurality of servers.

2. The building structure of claim 1, further comprising:

   a ceiling having one or more openings;
   a first space defined between the floor and the ceiling; and
   a second space defined between the ceiling and the roof portion and the protruding portion,
   wherein
   outside air enters the first space through the one or more openings on one or more of the lateral walls, and air in the first space exits, via natural convection, through one or more openings on at least one of the ceiling, the roof portion, and the protruding portion.

3. The building structure of claim 2, wherein air in the second space exits, via natural convection, through one or more openings located on the roof portion and the protruding portion.

4. The building structure of claim 2, wherein air in the second space enters the first space via one or more openings on the ceiling near one or more of the lateral walls and is mixed with the outside natural air entered into the first space.

5. The building structure of claim 1, wherein
   a first dimension is defined along a first direction between a first pair of opposing lateral walls;
   a second dimension is defined between a second set of opposing lateral walls aligning along a second direction perpendicular to the first direction;
   the first dimension relative to the second dimension is such that the building structure provides access to outside natural air via one or more openings on at least one of the lateral walls, wherein the second dimension is greater than the first dimension.

6. The building structure of claim 2, the shape of the building structure causes the air to be drawn, from the first space, through one or more servers of the plurality of servers in the first space, via natural convection, and hot air yielded by the servers to exit from the first space to the second space.

7. The building structure of claim 1, wherein the pitch is 1:x, where x is substantially larger than one, yielding a sloped roof that allows snow to build up and melt and heat from interior of the building structure accelerates the snow-melting process.

8. The building structure of claim 7, wherein x is 6.

9. The building structure of claim 2, wherein
at least one of the lateral walls is substantially louvered to allow the outside air to enter the building structure; and
at least one of the lateral walls has a portion above the ceiling substantially louvered to allow air to exit the building structure.

10. The building structure of claim 1, wherein the floor is a non-raised floor.

11. The building structure of claim 2 further comprising:

an air inlet coupled with an opening of one of the lateral walls and operable to allow outside natural air to enter;
one or more air-handling units coupled with the air inlet to draw the outside natural air and to provide air to the first space;
an air outlet coupled with an opening iof the roof or protruding portion and operable to allow air in the second space to exit; and
a control system configured to control the one or more air handling units to provide air to the first space in accordance with temperatures measured within and outside of the first space.

12. The building structure of claim 11, wherein the control system controls the one or more air-handling units to provide the outside natural air to the first space when the temperatures measured within and outside of the first place is within, a first range.

13. The building structure of claim 12, wherein when the temperatures measured within and outside of the first space is within a second range lower than the first range, the control system being arranged to control the one or more air-handling units to provide air to the first space based on a mixed outside natural air and air exhausted from the plurality of servers through one or more openings on the ceiling near the air inlet,

14. The system of claim 13, wherein when the temperatures measured within and outside of the first place is within a third range higher than the first range, the control system controls the one or more air-handling units to provide evaporative cooling air to the first space based on the outside natural air drawn from the air inlet through saturated media.

15. The system, of claim 14, wherein the first range is substantially between 70°F and 85°F, the second range is about below 70°F , and the third range is substantially between 85°F and 110°F.

FIG. 1

FIG. 2

FIG. 3

FIG. 4

FIG. 5

FIG. 6

FIG. 7

FIG. 8

FIG. 9

FIG. 10A

FIG. 10B

FIG. 11

FIG. 12

FIG. 13

EP 3 367 771 A1

FIG. 14

Europäisches
Patentamt

European
Patent Office

Office européen
des brevets

# EUROPEAN SEARCH REPORT

Application Number

EP 18 16 2564

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2011/009047 A1 (NOTEBOOM SCOTT [US] ET AL) 13 January 2011 (2011-01-13) | 1-8, 10-15 | INV. H05K7/20 F24F7/02 F24F7/06 F24F7/10 |
| Y | * paragraph [0046] - paragraph [0047]; figures 6,8,9 * ----- | 9 | |
| Y | US 1 230 305 A (KLAY ABRAHAM B [US]) 19 June 1917 (1917-06-19) * page 4, line 33 - line 38; figure 1 * ----- | 9 | |

TECHNICAL FIELDS
SEARCHED      (IPC)

H05K
F24F

The present search report has been drawn up for all claims

| Place of search | Date of completion of the search | Examiner |
|---|---|---|
| The Hague | 11 May 2018 | Boerrigter, Herman |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 18 16 2564

This annex lists the patent family members relating to the patent documents cited in the above-mentioned European search report.
The members are as contained in the European Patent Office EDP file on
The European Patent Office is in no way liable for these particulars which are merely given for the purpose of information.

11-05-2018

| Patent document cited in search report | | Publication date | Patent family member(s) | | Publication date |
|---|---|---|---|---|---|
| US 2011009047 | A1 | 13-01-2011 | AU 2010271314 | A1 | 19-01-2012 |
| | | | AU 2014202854 | A1 | 19-06-2014 |
| | | | AU 2016203877 | A1 | 30-06-2016 |
| | | | BR 112012000508 | A2 | 16-02-2016 |
| | | | CA 2765381 | A1 | 13-01-2011 |
| | | | CN 102473028 | A | 23-05-2012 |
| | | | CN 107728750 | A | 23-02-2018 |
| | | | EP 2452248 | A2 | 16-05-2012 |
| | | | JP 5826172 | B2 | 02-12-2015 |
| | | | JP 2012533123 | A | 20-12-2012 |
| | | | JP 2015072698 | A | 16-04-2015 |
| | | | JP 2017096619 | A | 01-06-2017 |
| | | | KR 20120027481 | A | 21-03-2012 |
| | | | KR 20140061435 | A | 21-05-2014 |
| | | | MY 161251 | A | 14-04-2017 |
| | | | NZ 597094 | A | 28-06-2013 |
| | | | RU 2012104532 | A | 20-08-2013 |
| | | | RU 2013156575 | A | 27-06-2015 |
| | | | SG 177494 | A1 | 28-02-2012 |
| | | | SG 10201401265X | A | 30-07-2014 |
| | | | TW 201111965 | A | 01-04-2011 |
| | | | US 2011009047 | A1 | 13-01-2011 |
| | | | WO 2011006027 | A2 | 13-01-2011 |
| US 1230305 | A | 19-06-1917 | NONE | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 50052009 A